# EUROPÄISCHE PATENTSCHRIFT

(11) **EP 3 876 065 B1**
(45) Veröffentlichungstag und Bekanntmachung des Hinweises auf die Patenterteilung: **15.01.2025**
(21) Anmeldenummer: 21170972.0
(22) Anmeldetag: 18.12.2017
(51) Int. Cl.: G05D 1/00, G03B 15/00, G08G 5/00

(54) **VERFAHREN ZUM BESTIMMEN EINES PFADES ENTLANG EINES OBJEKTS, SYSTEM UND VERFAHREN ZUM AUTOMATISCHEN INSPIZIEREN EINES OBJEKTS**
METHOD FOR DETERMINING A PATH ALONG AN OBJECT, SYSTEM AND METHOD FOR AUTOMATIC INSPECTING AN OBJECT
PROCÉDÉ DE DÉTERMINATION D'UN TRAJET LE LONG D'UN OBJET, SYSTÈME ET PROCÉDÉ D'INSPECTION AUTOMATIQUE D'UN OBJET

(30) Priorität: 14.03.2017 DE 102017204242; 03.04.2017 DE 102017205647
(43) Veröffentlichungstag der Anmeldung: 08.09.2021
(62) Teilanmeldung aus: 17828706.6
(73) Patentinhaber: TOP seven GmbH & Co. KG, 82319 Starnberg (DE)
(72) Erfinder: SCHICKEL, Peter, 82335 Berg (DE); SENG, Ulrich, 82319 Starnberg (DE); NEUBAUER, Oliver, 82131 Gauting (DE)
(74) Vertreter: Zimmermann, Tankred Klaus

(56) Entgegenhaltungen:
- WO-A1-2016/059785
- WO-A1-2016/149513
- WO-A2-2005/033629
- WO-A2-2009/142933
- JP-A- 2006 027 448
- KR-A- 20100 000 903
- US-A1- 2012 136 630
- US-A1- 2015 370 250
- US-B1- 9 513 635

## Beschreibung

Die vorliegende Erfindung bezieht sich auf ein Verfahren zum Bestimmen eines Pfades entlang eines Objekts, sowie ein System und ein Verfahren zum automatischen inspizieren eines Objekts. Ausführungsbeispiele beziehen sich auf eine Kameradrohne, die automatisch eine Strecke entlang eines Objekts abfliegt um Fotos von dem Objekt zu machen und mögliche Schäden zu detektieren. Weitere Ausführungsbeispiele zeigen eine Flugwegplanung aus mit geographischen GPS (Global Positioning System/Globales Positionsbestimmungssystem) Daten verschränkten 3D CAD-Modellen (CAD: computer-aided design, rechnerunterstütztes Konstruieren).

Bisher werden Kameras z.B. an Drohnen zur Inspizierung von Objekten von einem Piloten ferngesteuert. Hierbei treten jedoch verschiedene Nachteile auf. So kann die Überwachung der Position der Drohne nur rein visuell ohne elektronische Hilfsmittel erfolgen. Der Pilot verfolgt die Kamera demnach mit dem Auge und steuert diese vom Boden aus. Insbesondere bei weit entfernten Objekten wie z.B. den Blättern eines Windrads ist dies für den Piloten schwierig zu bewerkstelligen, da die Kamera zum einen sehr klein wird und teilweise kaum noch zu erkennen ist und ferner bei hoch gelegenen Objekten der Kopf weit in den Nacken gelegt werden muss. Auch die Steuerung der Kamera anhand eines Monitors, der das Kamerabild anzeigt, schafft keine Abhilfe, da hier ausschließlich die Sicht aus der "Ich-Perspektive" (First Person View) der Kamera verfügbar ist und keine Draufsicht auf die Drohne. Ferner haben beide Verfahren den Nachteil, dass eine bestimmte Stelle, beispielsweise dort wo ein Defekt erkannt wurde, nur nach Augenmaß erneut angeflogen werden kann, um die Stelle genauer zu inspizieren. Weiterhin ist mit dieser Handsteuerung weder eine Positionierung der Drohne mit einem konstanten Abstand zu einem Objekt, noch eine genaue Ausrichtung der Kamera zu dem Objekt noch eine Definition exakter Auslösepunkte einer Kamera zum Fotografieren des Objekts möglich. Somit ist eine Vermessung (bzw. Vermassung), d.h. die Bestimmung einer Größe von möglichen Fehler erschwert, da der Field-of-View des Bildes nicht bekannt ist.

WO 2016/059785 A1 bezieht sich auf die Steuerung eines Inspektionsfahrzeugs. Das Inspektionsfahrzeug umfasst ein Bilderfassungsgerät, welches mehrere Bilder aufnimmt, und eine Steuerungseinheit, die ein Kompositbild aus diesen Aufnahmen erstellt. Fluginformationen umfassen eine Liste von Positionen an welchen ein Bilderfassungsvorgang ausgeführt wird. Die Fluginformationen können Relativkoordinaten x, y und z umfassen. Den Bilderfassungspunkt können auch Absolutkoordinaten bezüglich eines Referenzpunkts zugewiesen sein. Die Relativkoordinaten können von den Absolutkoordinaten bezüglich des Referenzpunkts in Absolutkoordinaten konvertiert werden.

JP2006027448 bezieht sich auf ein Luftbildgerät unter Verwendung eines unbemannten Flugkörpers, der mit einer Kamera ausgestattet ist. Das Luftbildgerät arbeitet mit dem mit der Kamera ausgestatteten unbemannten Flugkörper und einem Mittel zum Aufzeichnen der von der Kamera gelieferten Bilddaten, mit denen der Abstand zwischen dem Rumpf des Flugkörpers und dem zu fotografierenden Objekt gemessen wird. Der Flug und das Objekt werden fotografiert, wenn die Zoomvergrößerung der Kamera auf der Grundlage des Messergebnisses festgelegt wird, und das Fotografieren erfolgt mit den Bilddaten des aufgenommenen Objekts, während die Ausrichtung der Kamera, die auf das Objekt gerichtet ist, während des Fluges in bestimmten Winkeln nach oben und unten sowie nach links und rechts geändert wird.

WO 2005/033629 A2 bezieht sich auf eine Technik zum Betrachten und Abbilden einer Unterwasserstruktur von einer Tauchplattform, Navigieren entlang der Struktur und Erstellen einer Karte der Struktur in Form eines Fotomosaiks und einer 3D-Strukturkarte. Das System kann eine Tauchplattform, mindestens zwei an die Tauchplattform gekoppelte Kameras und eine Stereovisionsanpassungslogik umfassen, die so programmiert ist, dass sie eine Frontalansicht einer Zielunterwasserstruktur aus einer festen Entfernung simuliert, basierend auf einer Schrägansicht der Zielunterwasserstruktur, die von der erhalten wird Kameras aus variabler Entfernung. Die Kameras können vorwärts oder seitlich an der Tauchplattform angebracht sein und können optische Kameras, akustische Kameras oder beides umfassen. Vorzugsweise kann die Tauchplattform ein ferngesteuertes Fahrzeug oder ein autonomes Unterwasserfahrzeug sein. Das System kann absolute Positionierungssensoren enthalten.

WO 2009/142933 A2 bezieht sich auf die Inspektion von Strukturen unter Verwendung mehrerer unabhängiger unbemannter mobiler Fahrzeuge. Die unbemannten Mobilfahrzeuge sind mit einem Steuerungs- und Leitsystem ausgestattet, damit jedes unbemannte Mobilfahrzeug autonom arbeiten kann. Jedes unbemannte mobile Fahrzeug kann mit einem Betriebsprogramm programmiert werden, das einen Fahrweg für es relativ zu einer zu inspizierenden Struktur definiert. Die unbemannten mobilen Fahrzeuge werden so eingesetzt, dass sie gemeinsam einen Schwarm bilden, der sich über die Struktur bewegt. Mindestens eines der unbemannten mobilen Fahrzeuge wird verwendet, um Inspektionsdaten eines Teils der Struktur zu erhalten, während es sein jeweiliges Betriebsprogramm ausführt.

US9513635 bezieht sich auf ein unbemanntes Luft-Inspektionssystem. Dies umfasst ein unbemannten Luftfahrzeug ausgeführt und umfasst das Erhalten von Flugbetriebsinformationen, die eine Inspektion einer durchzuführenden vertikalen Struktur beschreiben, von einem Benutzergerät, die Flugbetriebsinformationen umfassen Standorte eines oder mehrerer sicherer Standorte für die vertikale Inspektion. Ein Ort des unbemannten Luftfahrzeugs wird bestimmt, der einem ersten sicheren Ort für die vertikale Inspektion entspricht. Eine erste Inspektion der Struktur wird am ersten sicheren Ort durchgeführt, wobei die erste Inspektion das Aktivieren von Kameras umfasst. Ein zweiter sicherer Ort wird angefahren, und eine zweite Inspektion der Struktur wird durchgeführt. Mit der Inspektion verbundene Informationen werden dem Benutzergerät bereitgestellt.

KR 2010 0000903 A befasst sich mit einem Verfahren zur Begutachtung einer Unterseite einer Brücke. Dazu offenbart die Druckschrift die Verwendung eines Inspektionsfahrzeugs, welches einen über mehrere Drehachsen beweglichen Arm verfügt, um Bildaufnahmen von der Unterseite der Brücke machen zu können.

Der vorliegenden Erfindung liegt somit die Aufgabe zugrunde, ein verbessertes Konzept zum Inspizieren eines Objekts zu schaffen.

Diese Aufgabe wird durch den Gegenstand der unabhängigen Patentansprüche gelöst. Erfindungsgemäße Weiterbildungen sind in den Unteransprüchen definiert.

Ausführungsbeispiele zeigen ein Verfahren zum Bestimmen eines Pfades entlang eines Objekts. Das Verfahren umfasst einen Schritt "Bestimmen eines Referenzpunktes des Objekts in absoluten Koordinaten (z.B. Koordinaten in einem Weltkoordinatensystem)", einen Schritt "Ermitteln einer Menge von Punkten des Objekts in absoluten Koordinaten basierend auf weiteren Punkten des Objekts in einem relativen Koordinatensystem, wobei die Umrechnung der weiteren Punkte des Objekts in das absolute Koordinatensystem basierend auf dem Referenzpunkts des Objekts erfolgt" und einen Schritt "Bestimmen des Pfads entlang des Objekts basierend auf der Menge von Punkten des Objekts, so dass der Pfad beabstandet von dem Objekt verläuft".

In anderen Worten können die relativen Koordinaten als Koordinaten in einem ersten Koordinatensystem aufgefasst werden. Analog können die absoluten Koordinaten als Koordinaten in einem zweiten Koordinatensystem aufgefasst werden, wobei sich das erste Koordinatensystem von dem zweiten Koordinatensystem unterscheidet. Der Pfad bzw. Koordinaten des Pfades liegen dann beispielsweise in Koordinaten des zweiten Koordinatensystems vor, um wie in nachfolgenden Ausführungsbeispielen beschrieben, z.B. einer beweglichen Aufnahmeeinheit zu ermöglichen, dem Pfad zu folgen. In Ausführungsbeispielen kann die bewegliche Aufnahmeeinheit Koordinaten des zweiten Koordinatensystem messen bzw. bestimmen, nicht jedoch Koordinaten des ersten Koordinatensystems.

Der vorliegenden Erfindung liegt die Idee zu Grunde, das Inspizieren von Objekten zu automatisieren. Hierzu ist es zunächst wichtig, dass eine Route entlang des Objekts bestimmt wird, entlang derer das Objekt inspiziert werden kann. Hierbei ist es zunächst wichtig, die genaue Position des Objekts zu ermitteln. Häufig ist jedoch nur die Bemaßung beispielsweise aus Maßzeichnungen oder (3D-) Computermodelle von dem Objekt bekannt, nicht jedoch absolute Koordinaten z.B. eines geographischen Koordinatensystems, des Objekts. Diese Koordinaten werden nachfolgend auch als relative Koordinaten bezeichnet. Um die absoluten Koordinaten zu erhalten reicht es dann jedoch aus, nur einen Punkt des Objekts absolut zu ermitteln und die weiteren Punkte in relativen Koordinaten basierend auf dem Referenzpunkt in absolute Koordinaten zu transformieren. So kann eine aufwendige Positionsbestimmung von einer Vielzahl von Referenzpunkten vermieden werden. Die absoluten Koordinaten können dann für die Positionsbestimmung des Pfads herangezogen werden, so dass auch die (Eck-) Punkte des Pfads (bzw. Polygons) in absoluten Koordinaten vorliegen.

In Ausführungsbeispielen werden Koordinaten des Pfades relativ zu zumindest einem Punkt aus der Menge von Punkten (bzw. relativ zu dem Objekt) bestimmt. Das heißt, die Punkte des Pfades liegen in absoluten Koordinaten vor, sind jedoch nicht fest (bzw. konstant), sondern können einer Bewegung des Objekts folgen. Windräder beispielsweise werden typischerweise in den Wind gedreht, auch wenn diese nicht in Betrieb sind. Wird der Pfad nun einer Bewegung des Rotors (bzw. des Windrads) nachgeführt, so liegt dieser immer in der gleichen Position relativ zu dem Windrad, also beispielsweise den Rotorblättern. Die Bewegung des Windrads kann anhand einer Abweichung der Position des Referenzpunkts zwischen dem Ermitteln der Menge der Punkte in absoluten Koordinaten und der aktuellen Position des Referenzpunktes bestimmt werden. Da der Referenzpunkt vorteilhafterweise an der (Außen-) Oberfläche des Objekts liegt, bewegt sich dieser auch bei einer Rotation des Objekts mit. Die Rotationsachse des Objekts befindet sich typischerweise in Inneren des Objekts. Kann sich das Objekt sowohl translatorisch als auch rotatorisch bewegen, können ferner zwei Referenzpunkte an dem Objekt bestimmt werden.

Bei Ausführungsbeispielen wird der Pfad, z.B. eine Flugbahn, auf dem sich eine bewegliche Einheit, z.B. eine Drohne, entlang des Objekt bewegt, basierend auf einem 3D- oder Gittermodell des Objekts festgelegt. Die lokalen Koordinaten des Modells werden über den zumindest einen Referenzpunkt in absolute Koordinaten zur Steuerung der beweglichen Einheit anhand der absoluten Koordinaten (z.B. GPS Koordinaten) umgewandelt. Bei solchen Ausführungsbeispielen kann eine Bewegung des Objekts oder eines Teils des Objekts, z.B. eines Rotorblattes eines Windrades, in dem Modell in Echtzeit abgebildet werden, so dass ausgehend von dem modifizierten Modell die Flugbahn ebenfalls in Echtzeit an die Bewegung des Objekts angepasst wird. Diejenigen Punkte der Flugbahn, die durch die Bewegung des Objekts betroffen sind, werden z.B. basierend auf den Koordinaten des modifizierten Modells angepasst. Die Bewegung des Objekts kann entweder eine kontinuierliche oder andauernde Bewegung des Objekts oder eines Teils des Objekts sein, z.B. sich im Wind drehende Rotorblätter eines Windrades, oder es ist eine Änderung einer Orientierung des Objekts oder eines Teils des Objekts, z.B. die Bewegung eines ausgekoppelten Rotorblattes eines Windrades von einer ersten Position in eine zweite Position, z.B. aufgrund einer Windbö.

Bei anderen Ausführungsbeispielen kann das Objekt ein Flugzeug sein, das zu inspizieren ist. Bei einer solchen Ausführungsform kann die oben angesprochene Bewegung des Objekts die Bewegung des Leitwerks des Flugzeugs von einer ersten Position in eine zweite Position sein, z.B. aufgrund einer Windbö.

Die Abbildung dieser Bewegungen in das Modell ermöglicht gemäß Ausführungsbeispielen die Möglichkeit, die Flugbahn entlang des Objekts in Echtzeit an die sich ändernden Gegebenheiten anzupassen. Gemäß Ausführungsbeispielen wird eine Bewegung der Einheit, z.B. der Drohne, entlang des sich bewegenden Objekts oder entlang des sich bewegenden Teils des Objekts ermöglicht wird.

Die Bestimmung der Koordinaten relativ zu dem Objekt kann durch Bestimmen des Pfades anhand eines einzuhaltenden Abstands zu dem Objekt erfolgen. Hierbei kann der Abstand zu dem Objekt senkrecht zu Polygonflächen zwischen der Menge von Punkten des Objekts ermittelt werden. Dieses Verfahren ermöglicht eine optimale Positionierung des Pfades zu dem aufzunehmenden Objekt um beispielsweise Aufnahmen oder Messungen entlang des Pfades von bzw. an dem Objekt durchzuführen. Ergänzend oder alternativ kann der Pfad auch derart bestimmt werden, dass der Pfad zumindest 40%, zumindest 60% oder zumindest 80% seiner Gesamtlänge parallel zu Polygonflächen zwischen der Menge von Punkten des Objekts verläuft. Polygonflächen können benachbarte Punkte/Vertices verbinden, um die Oberfläche des Objekts aufzuspannen und ein Modell des Objekts zu erzeugen.

Ausführungsbeispiele zeigen ferner, dass das Bestimmen des Pfades eine manuelle Eingabe des Pfades in relativen Koordinaten umfasst. Die relativen Koordinaten des Pfades können dann in absolute Koordinaten umgerechnet werden, um den Pfad (bzw. Koordinaten desselben) in absoluten Koordinaten zu erhalten. In anderen Worten ist auch eine manuelle Eingabe von Koordinaten des Pfades möglich. Diese Koordinaten können über ein CAD System eingegeben werden, d.h. sie können entlang des 3D Modells eingegeben werden. Die Eingabe der Koordinaten kann vollständig manuell erfolgen, d.h. ohne vorab (automatisch) berechneten Pfad. Ergänzend oder alternativ kann ein vorhandener Pfad manuell geändert werden, in dem z.B. einzelne Koordinaten des Pfades verschoben werden. Somit kann der Pfad sogar während sich beispielsweise eine automatische Aufnahmeeinrichtung entlang des Pfads bewegt, dynamisch angepasst werden.

In Ausführungsbeispielen geht dem Ermitteln der Menge von Punkten das Erstellen einer 3D Darstellung des Objekts in dem relativen Koordinatensystem voran. Dies ist beispielsweise vorteilhaft, wenn noch kein 3D Modell des Objekts vorliegt, sondern nur eine Maßzeichnung oder gar keine Bemaßungen des Objekts vorliegen. Fehlen Maßangaben können diese vorab ermittelt werden oder es kann eine Interpolation zwischen zumindest 2 Punkten vorgenommen werden. So kann beispielsweise bei einem zylinderförmigen Objekt die Oberfläche aus einem bekannten Durchmesser oder Radius interpoliert werden. Dies ist analog auf andere Formen des Objekts übertragbar. Sind nun die Menge der Punkte auf der Oberfläche des Objekts aus dem 3D Modell in absoluten Koordinaten (also bezogen auf den Referenzpunkt) bekannt, kann der Pfad nun einfacher, beispielsweise mit einer der vorab beschriebenen Ausführungsbeispiele, ermittelt werden.

Ausführungsbeispiele zeigen ferner ein Verfahren zum automatischen Inspizieren eines Objekts unter Nutzung des vorstehend beschriebenen Verfahrens. Ferner umfasst das Verfahren das automatische Bewegen einer beweglichen Aufnahmeeinheit auf einem Pfad entlang des Objekts und das Erzeugen einer Abfolge von Bildern von dem Objekt um das Objekt zu inspizieren. Dieses Verfahren kann von dem nachfolgend beschriebenen System ausgeführt werden.

Ausführungsbeispiele zeigen ferner ein System zum automatischen Inspizieren eines Objekts. Das System weist eine beweglichen Aufnahmeeinheit auf, die ausgebildet ist, sich automatisch auf einem Pfad entlang des Objekts zu bewegen. Ferner umfasst das System eine Recheneinheit, die ausgebildet ist einen Referenzpunkt des Objekts in absoluten Koordinaten zu bestimmen, weitere Punkte des Objekts relativ zu dem Referenzpunkt zu ermitteln um eine Menge von Punkten des Objekts in absoluten Koordinaten zu erhalten und den Pfads entlang des Objekts basierend auf der Menge von Punkten des Objekts zu bestimmen, so dass der Pfad beabstandet von dem Objekt verläuft. Die bewegliche Aufnahmeeinheit kann nun das Objekt entlang des Pfades inspizieren. Hierzu kann die bewegliche Aufnahmeeinheit einen Positionsbestimmer (z.B. GPS Empfänger) aufweisen, der die absoluten Koordinaten misst. Die bewegliche Aufnahmeeinheit kann dann einen Abstand zwischen dem Pfad (bzw. eines anzusteuernden Punktes auf dem Pfad) und einer ermittelten Position des Positionsbestimmers minimieren, um die bewegliche Aufnahmeeinheit entlang des Pfades zu bewegen und das Objekt von den Punkten entlang des Pfades zu inspizieren. Dieses automatisierte Verfahren (bzw. Bewegen) der Aufnahmeeinheit resultiert auch darin, dass die bewegliche Aufnahmeeinheit automatisch an einen beliebigen Punkt des Pfades und somit auch an eine beliebige Stelle des Objekts gesteuert werden kann um beispielsweise Messungen an dem Punkt vorzunehmen oder ein Bild von einer bestimmten Stelle des Objekts zu erzeugen. So in Ausführungsbeispielen während eines Übersichtsfluges eine Drohne entlang des Objekts (z.B. dem Windrad) fliegen. Auf den Aufnahmen kann dann ein potentieller Defekt erkannt werden, der jedoch in dem Übersichtsbild nicht genau erkennbar ist. Um die Auflösung des Bildes an der Stelle zu erhöhen, kann die bewegliche Aufnahmeeinheit mit einem anderen Objektiv (mit größerer Brennweite) ausgestattet werden oder an einen Punkt der näher an dem Objekt liegt als der ursprüngliche Auslösepunkt liegt, fliegen, um eine Detailaufnahme von dem potentiellen Defekt zu erzeugen.

Gemäß Ausführungsbeispielen ist die bewegliche Aufnahmeeinheit ausgebildet, zum Inspizieren des Objekts eine Abfolge von Bildern von dem Objekt zu erzeugen oder eine Messung an dem Objekt durchzuführen. Die Bilder können mittels eines beliebigen Bildgebenden Verfahrens aufgenommen werden. Als Messung kommen z.B. berührungslose Messungen in Betracht, z.B. die Durchgangsprüfung eines Blitzableiters, bei der berührungslos ein Strom in den Blitzableiter induziert wird oder auch eine Abstandsmessung z.B. mittels kapazitiver oder induktiver Sensoren die beispielsweise Oberflächendefekte erkennen können. Auch Temperaturmessungen eines Punktes z.B. mittels eines Infrarotthermometers oder einer (bildgebenden) Wärmebildkamera kommen in Betracht. Ferner können auch berührungsbehaftete Sensoren verwendet werden. So kann beispielsweise die Durchgangsprüfung des Blitzableiters alternativ auch mittels eines Gleitkontakts, also einer Bürste oder eines Besens, erfolgen, wobei über den Gleitkontakt eine Spannung an den Blitzableiter angelegt oder ein Strom in den Blitzableiter eingeprägt werden kann. Die bewegliche Aufnahmeeinheit kann dann so verstanden werden, als dass diese die Messungen aufnimmt. Alternativ kann eine Spannung extern (z.B. über ein entsprechendes Prüfsystem an der Spitze eines Windrads) an den Blitzableiter angelegt werden. Die bewegliche Aufnahmeeinheit ist dann ausgebildet, eine Feldstärke in dem Blitzableiter zu messen.

Ausführungsbeispiele zeigen ferner die Recheneinheit, die ausgebildet ist, entlang des Pfades Auslösestellen für die beweglich Aufnahmeeinheit abhängig von einem Sichtfeld der beweglichen Aufnahmeeinheit zu definieren. Das Sichtfeld der beweglichen Aufnahmeeinheit kann z.B. durch die Brennweite und/oder Auflösung eines Objektivs der Aufnahmeeinheit beeinflusst bzw. eingestellt werden. In anderen Worten kann das Sichtfeld ein Ausschnitt der Umgebung sein, der durch die bewegliche Aufnahmeeinheit aufgenommen werden kann. Die bewegliche Aufnahmeeinheit ist nun ausgebildet, an den Auslösestellen ein Bild zu erzeugen (bzw. aufzunehmen). Dies ist vorteilhaft, da somit vorab, beispielsweise basierend auf dem verwendeten Objektiv und/oder dem Abstand des Pfads (d.h. der beweglichen Aufnahmeeinheit) von dem Objekt die Anzahl der benötigten Bilder festgelegt wird. Die Festlegung kann vorteilhafterweise örtlich erfolgen, so dass die Aufnahmeeinheit bei Erreichen einer Auslösestelle auslöst und nicht wahllos innerhalb von bestimmten Zeitabständen. Somit kann die Anzahl der Bilder (oder Aufnahmen) auf ein minimal benötigtes Maß verringert werden. Dies können für ein Blatt/Flügel eines Windrads weniger als 100 Aufnahmen, weniger als 60 Aufnahmen oder weniger als 40 Aufnahmen sein um dieses von beiden Seiten zu inspizieren. Dies reduziert den Aufwand der Auswertung der Bilder im Vergleich zu einer unkontrollierten bzw. auf einem reinen Zeitabstand basierenden Auslösen (oder sogar einem Video).

In Ausführungsbeispielen weist das System eine Auswerteeinheit auf, die ausgebildet ist, die Bilder von dem Objekt auf ein Modell des Objekts zu projizieren, um ein Modell mit der aktuellen Oberfläche des Objekts zu erhalten. Somit können die aufgenommenen Bilder beispielsweise dem vorhandenen oder erzeugten 3D Modell überlagert werden. Die Projektion (bzw. Überlagerung) kann in Ausführungsbeispielen basierend auf einer aktuellen Position und einer Aufnahmerichtung der Aufnahmeeinheit zu einem Zeitpunkt der Bildaufnahme erfolgen. Die Bilder können somit anhand ihrer absoluten Position dem Objekt, dessen absolute Position der Menge der Punkte (bzw. der absoluten Position dessen Oberfläche) bekannt ist, überlagert werden. Die absolute Position der Bilder kann aus der realen Position der Aufnahmeeinheit und einer Ausrichtung der Aufnahmeeinheit bestimmt werden. Basierend auf einer Abweichung der Position der Aufnahmeeinheit bei der Aufnahme des Bildes von der vorgesehenen Auslösestelle Abbildungsfehler (z.B. perspektivische Verzerrungen) der Aufnahmen durch den abweichenden Aufnahmewinkel kompensiert werden.

Gemäß Ausführungsbeispielen ist die bewegliche Aufnahmeeinheit ausgebildet, eine Aufnahmerichtung auf einen Punkt aus der Menge der Punkte einzustellen. In anderen Worten richtet die bewegliche Aufnahmeeinrichtung eine Kamera derart aus, dass diese auf einen vorbestimmten Punkt des Objekts ausgerichtet ist und ein Bild in diese Richtung aufnimmt, unabhängig von einer aktuellen (absoluten oder räumlichen) Position der beweglichen Aufnahmeeinrichtung. In nochmals anderen Worten ist das Heading der Aufnahmeeinrichtung auf den vorbestimmten Punkt des Objekts ausgerichtet. Somit wird sichergestellt, dass die bewegliche Aufnahmeeinheit auch den gewünschten Bildausschnitt aufnimmt und nicht beispielsweise von dem Objekt weggedreht ist. Ferner können derart auch größere Abweichungen der Aufnahmeeinheit von einer vorbestimmten Auslösestelle toleriert werden, da aufeinanderfolgende Bilder sich (ca. um einen eingestellten Wert) überlappen und somit von allen Stellen des Objekts eine Aufnahme erhalten wird ohne einen Oberflächenbereich auszulassen, der aufgenommen werden sollte. Potentiell auftretende Abbildungsfehler (dadurch, dass das Objekt nicht im rechten Winkel aufgenommen wird sondern schräg, d.h. mit einem von dem rechten Winkel abweichenden Winkel), können kompensiert werden. Wird ein Oberflächenbereich des Objekts jedoch nicht aufgenommen, so muss die bewegliche Aufnahmeeinheit diese Stelle nochmal anfliegen, um nicht auf Informationen zu diesem Oberflächenbereich verzichten zu müssen.

In anderen Worten kann die bewegliche Aufnahmeeinheit eine beliebige Auswahl, d.h. eine Teilmenge oder jeden Wert, aus den nachfolgenden Messwerten ermitteln: eine (aktuelle) absolute (z.B. GPS) Position der beweglichen Aufnahmeeinheit, eine (aktuelle) Zielposition (z.B. GPS) auf dem Pfad, eine Ausrichtung (Heading) der beweglichen Aufnahmeeinheit, wobei die Ausrichtung eine Rotation entlang einer Längsachse der beweglichen Aufnahmeeinheit (Rollen, Wanken), eine Rotation entlang einer Querachse (Nicken, Stampfen) und/oder eine Rotation entlang einer Vertikalachse (Gieren, Schlingern) umfasst. In Ausführungsbeispielen, in denen die bewegliche Aufnahmeeinheit eine Kamera umfasst, die an einem (steuerbaren) Fortbewegungsmittel (z.B. Drohne, Roboter, U-Boot, Flugzeug etc.) angebracht ist, kann die Ausrichtung sowohl des beweglichen Objekts als auch der Kamera selber erfasst werden, wobei die Kamera selber (unabhängig von dem beweglichen Objekt) um zumindest eine Achse rotiert werden kann. Aus diesen Daten kann ein Winkel der Kamera auf das Objekt derart eingestellt werden, dass die Kamera auf einen vorgegebenen Punkt des Objekts ausgerichtet. Anhand des eingestellten Winkels der Kamera (absolut zu dem Objekt oder relativ zu dem Fortbewegungsmittel) kann ferner das aufgenommene Bild derart entzerrt bzw. bearbeitet werden, als wäre es von vorne, d.h. (ungefähr) in einem 90° Winkel zu dem Objekt aufgenommen worden.

Bevorzugte Ausführungsbeispiele der vorliegenden Anmeldung werden nachfolgend Bezug nehmend auf die beiliegenden Zeichnungen näher erläutert. Es zeigen:
- Fig. 1: eine schematische Blockdarstellung eines Verfahrens zum Bestimmen eines Pfades entlang eines Objekts;
- Fig. 2: eine schematische Blockdarstellung eines Verfahrens zum automatischen Inspizieren eines Objekts;
- Fig. 3: eine schematische Darstellung eines Systems zum automatischen Inspizieren eines Objekts;
- Fig. 4: eine schematische Darstellung eines Pfads entlang eines Objekts gemäß einem Ausführungsbeispiel;
- Fig. 5: eine schematische Darstellung der Umrechnung von Punkten eines Objekts in relativen oder lokalen Koordinaten (Fig. 5a) in absolute Koordinaten (Fig. 5b) anhand eines Ausführungsbeispiels;
- Fig. 6: eine schematische Darstellung der Einstellung der Blickwinkel einer beweglichen Aufnahmeeinrichtung gemäß Ausführungsbeispielen; und
- Fig. 7: ein Ausführungsbeispiel gemäß dem die bewegliche Aufnahmeeinheit ausgebildet ist, eine Feldstärke eines elektrischen Feldes berührungslos bzw. kontaktlos zu erfassen, dass durch einen Stromfluss in einem Leiter in einem zu inspizierenden Objekt hervorgerufen wird.

In der nachfolgenden Beschreibung der Figuren werden gleiche oder gleichwirkende Elemente mit den gleichen Bezugszeichen versehen, so dass deren Beschreibung in den unterschiedlichen Ausführungsbeispielen untereinander austauschbar ist.

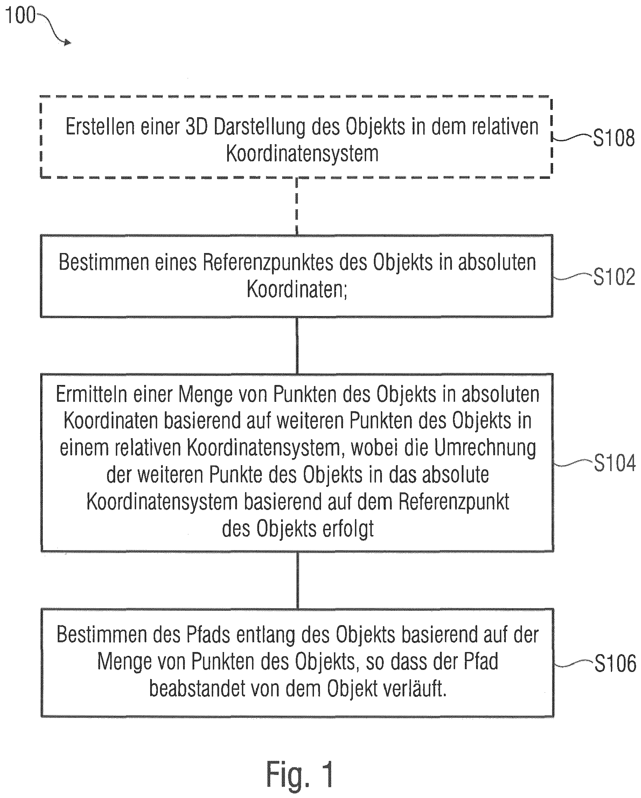

Fig. 1 zeigt eine schematische Blockdarstellung eines Verfahrens 100 zum Bestimmen eines Pfades entlang eines oder mehrerer Objekte, wobei nachfolgend vereinfachend von einem Objekt ausgegangen wird ohne, ohne den Anspruch auf Allgemeingültigkeit zu verlieren. Der Pfad ist beispielsweise eine Flugroute, eine Fahrtroute, eine Tauchroute usw., der (bzw. dessen Punkte) in Ausführungsbeispielen in drei Dimensionen bzw. Raumrichtungen bestimmt wird. Das Verfahren 100 weist die Schritte S102, S104 und S106 auf. Schritt S102 umfasst das Bestimmen eines Referenzpunktes des Objekts in absoluten Koordinaten. Die absoluten Koordinaten sind beispielsweise GPS-Koordinaten, also Koordinaten in einem auf die Erde bezogenen Koordinatensystem bzw. einem absolutes geographisches Koordinatensystem (Geo-Centered-Coordinatesystem, GCC). Die absoluten Koordinaten können mit einer Abweichung von weniger als 10cm, weniger als 1cm oder weniger als 0,5cm bestimmt werden. Dies kann z.B. unter Verwendung von RTK (Real Time Kinematik, Echtzeitkinematik) Systemen zur Vermessung erreicht werden, die eine Genauigkeit von z.B. einem Zentimeter oder mehr bzw. besser erreichen können.

Schritt S104 umfasst das Ermitteln einer Menge von Punkten des Objekts in absoluten Koordinaten basierend auf weiteren Punkten des Objekts in einem relativen Koordinatensystem, wobei die Umrechnung der weiteren Punkte des Objekts in das absolute Koordinatensystem basierend auf dem Referenzpunkt des erfolgt. Die Menge von Punkten kann den Referenzpunkt sowie weitere Punkte aufweisen. In anderen Worten können Gitterpunkte des Objekts die Menge von Punkten des Objekts bilden. Für jeden (relevanten) Gitterpunkt sind die absoluten Koordinaten (z.B. GPS Koordinaten) bekannt bzw. werden ermittelt. Relevante Gitterpunkte können solche Gitterpunkte sein, die dem Pfad zugewandt sind. In anderen Worten kann die Gitterpunktdichte des Objekts bzw. der Oberfläche des Objekts, für die die absoluten Koordinaten bestimmt werden, an einem dem Pfad zugewandten Bereich größer sein als an anderen Bereichen des Objekts, an denen der Pfad nicht (direkt) vorbeiführt. Die weiteren Punkte (bzw. Vertices) können (Gitter-) Punkte der Außenhülle bzw. der Oberfläche des Objekts sein.

Das relative Koordinatensystem kann z.B. das CAD Koordinatensystem sein, in dem das 3D Modell vorliegt. Alternativ können auch einfache Bemaßungen (d.h. Maßangaben bzw. Abmessungen des Objekts) als ein relatives Koordinatensystem betrachtet werden. In anderen Worten wird das relative Koordinatensystem zur Abgrenzung zu dem absoluten Koordinatensystem eingeführt um zu verdeutlichen, dass eine Navigation in dem relativen Koordinatensystem nicht möglich ist.

Der Schritt S106 umfasst das Bestimmen des Pfads entlang des Objekts basierend auf der Menge von Punkten des Objekts, so dass der Pfad beabstandet von dem Objekt verläuft.

Optional kann das Verfahren 100 einen weiteren Schritt S108 aufweisen. Der Schritt S108 umfasst das Erstellen einer 3D Darstellung des Objekts in dem relativen Koordinatensystem. Dies geht dem Ermitteln der Menge von Punkten des Objekts voran. Somit kann der Schritt S108 vor oder parallel zu dem Schritt s102 oder vor dem Schritt S104 ausgeführt werden. Das Erstellen der 3D Darstellung kann mit CAD Systemen erfolgen.

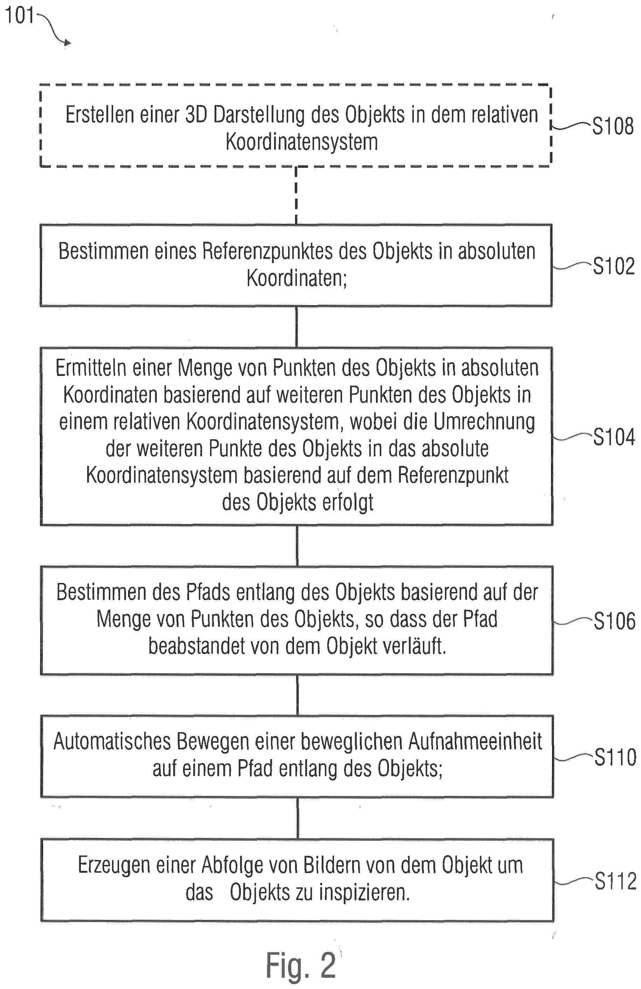

Fig. 2 zeigt eine schematische Blockdarstellung eines Verfahrens 101 zum automatischen Inspizieren eines Objekts. Das Verfahren 101 weist die Schritte des Verfahrens 100 auf. Dies sind die Schritte S102, S104, S106 und optional S110. Ergänzend weist das Verfahren 101 die Schritte S110 und S112 auf. Schritt S110 umfasst das automatische Bewegen einer beweglichen Aufnahmeeinheit auf einem Pfad entlang des Objekts. Schritt S112 umfasst ferner das Inspizieren des Objekts entlang des Pfades. Zum Inspizieren des Objekts können eine Abfolge von Bildern von dem Objekt erzeugt werden oder es können Messungen an dem Objekt vorgenommen werden, wie beispielsweise eine Durchgangsprüfung eines Blitzableiters. Ferner können in dem Verfahren die Schritte analog zu den Merkmalen des nachfolgend beschriebenen Systems ausgeführt werden.

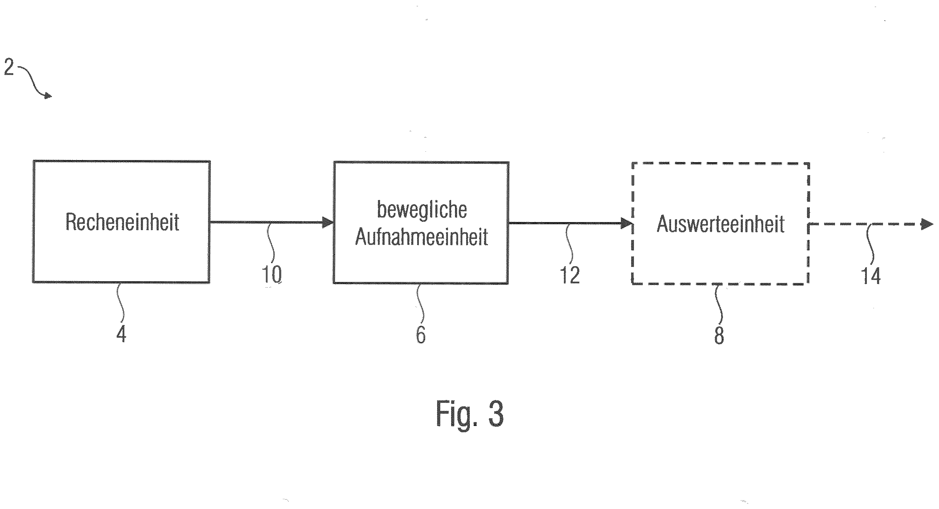

Fig. 3 zeigt eine schematische Blockdarstellung eines Systems 2 zum automatischen Inspizieren eines Objekts. Das System 2 weist eine Recheneinheit 4 und eine bewegliche Aufnahmeeinheit 6 auf. Die Recheneinheit 4 ist ausgebildet, einen Referenzpunkt des Objekts in absoluten Koordinaten zu bestimmen, weitere Punkte des Objekts relativ zu dem Referenzpunkt zu ermitteln um eine Menge von Punkten des Objekts in absoluten Koordinaten zu erhalten und den Pfad 10 entlang des Objekts basierend auf der Menge von Punkten des Objekts zu bestimmen, so dass der Pfad beabstandet von dem Objekt verläuft. In anderen Worten ist die Recheneinheit ausgebildet, die Verfahrensschritte des Verfahrens 100 auszuführen. Die Recheneinheit kann ferner zentral, d.h. z.B. bei einem Piloten oder in einem Rechenzentrum angeordnet sein, um den Pfad einmal initial zu bestimmen. Die bewegliche Aufnahmeeinheit kann den Pfad dann speichern. Sofern es erforderlich ist, den Pfad nachzuführen, weil sich das Objekt (während der Messung oder zwischen dem Erstellen des initialen Pfades oder dem Bestimmen des Referenzpunktes und dem Beginn der Inspektion des Objekts) bewegt, kann die bewegliche Aufnahmeeinheit mit der Recheneinheit verbunden sein oder eine Teilrecheneinheit aufweisen, um den Pfad z.B. gemäß der Abweichung des Referenzpunkts von seiner aktuellen Position zu seiner ursprünglichen Position, nachführen zu können. In der beweglichen Aufnahmeeinheit kann ferner ein Empfänger für die absoluten Positionsdaten (z.B. GPS) angeordnet sein.

Die bewegliche Aufnahmeeinheit 6 kann ferner das Objekt entlang des Pfades inspizieren. Während oder nach der Inspektion kann die Aufnahmeeinheit 6 ein Ausgangssignal 12 ausgeben. In Ausführungsbeispielen umfasst das Inspizieren des Objekts das Erzeugen einer Abfolge von Bildern von dem Objekt oder das Durchführen einer Messung an dem Objekt. Somit kann das Ausgangssignal 12 ein Bild bzw. eine Abfolge von Bildern sein oder ein (oder mehrere) Messergebnis. Die Aufnahmeeinheit kann demnach eine Kamera sein, die, um sie beweglich zu machen, z.B. an einer Drohne oder einem Roboter etc. befestigt ist.

Beweglich bezieht sich hierbei auf die Möglichkeit, die Aufnahmeeinheit entlang eines Pfades zu verfahren bzw. dem Pfad zu folgen. Die Beweglichkeit kann sich auf alle (der) Raumrichtungen erstrecken. Die bewegliche Aufnahmeeinheit kann ein Roboter, Boot, U-Boot, Drohne, Flugzeug etc. mit einer (Foto-) Kamera ausgestattet sein. Die Kamera kann Aufnahmen mittels eines beliebigen bildgebenden Verfahrens (Time of Flight, Röntgen, Fotografie usw.) aufnehmen. Alternativ zu der Kamera können Sensoren zur Bestimmung/Aufnahme von Eigenschaften des Objekts verwendet werden.

Optional weist das System 2 ferner eine Auswerteeinheit 8 auf, die das Ausgangssignal 12 auswertet. Hat die bewegliche Aufnahmeeinheit eine Abfolge von Bildern von dem Objekt aufgenommen, kann die Auswerteeinheit 8 diese Bilder auf ein Modell des Objekts projiziert, um ein Modell 14 mit der aktuellen Oberfläche des Objekts zu erhalten. Die aktuelle Oberfläche wird demnach durch die aufgenommenen Bilder gebildet. Die Abfolge von Bildern können ein Video, Fotos, Thermalbilder, Röntgenaufnahmen, Time-of-Flight Bilder usw. sein.

Das Projizieren kann basierend auf den GPS Daten d.h. der absoluten Koordinaten der Bilder bzw. der Position der beweglichen Bildaufnahmeeinheit erfolgen. Hierzu können die Aufnahmen mit den GPS Koordinaten der Auslösestellen (=Auswerteeinheit) versehen werden (RTK Genauigkeit beispielsweise ca. 1 cm), so dass die Texturen auf das GPS Koordinatenmodell (3D Modell) projiziert werden können.

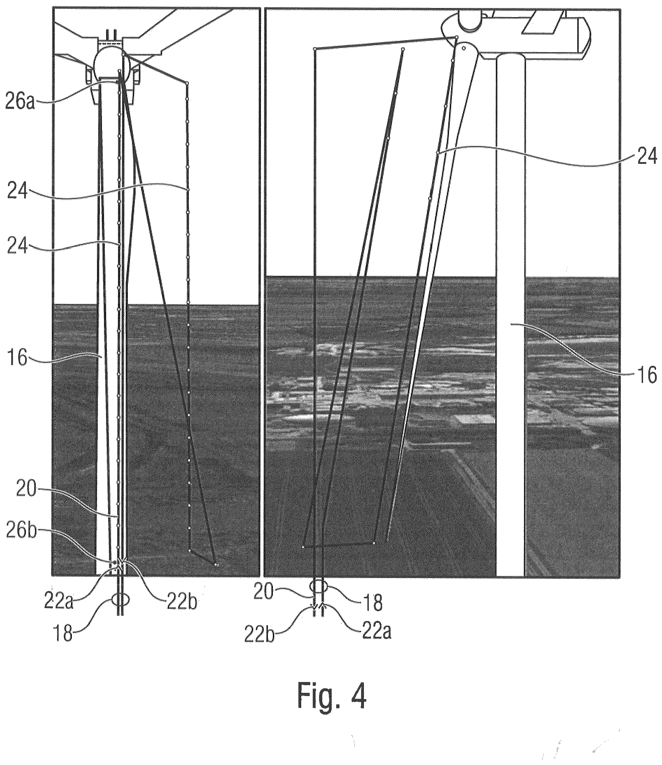

Fig. 4 zeigt eine schematische Darstellung des Systems beispielhaft an einer 3D Darstellung eines Windrad (bzw. Blätter des Windrads) als Objekt 16. Schematisch ist ferner eine Drohne bzw. ein unbemanntes Flugobjekt als beweglichen Aufnahmeeinheit 18 gezeigt. Sowohl das Objekt 16 als auch die bewegliche Aufnahmeeinheit 18 sind jedoch beliebig austauschbar. Nur beispielhaft sei ein U-Boot als bewegliche Aufnahmeeinheit 18 erwähnt, das automatisch entlang eines Pfades ein Objekt unter Wasser inspiziert. Eine Navigation, d.h. die Bestimmung der aktuellen Position des U-Boots kann z.B. mittels Weiterleitung (Relay) des GPS Signals erfolgen, wobei das GPS Signal in ein Signal einer Wellenlänge umgesetzt wird, mit der es sich unter Wasser (weit genug) ausbreiten kann.

Das Ausführungsbeispiel ist in Fig. 4 aus zwei verschiedenen Perspektiven aufgenommen, aus denen auch die räumliche Orientierung des Pfades 20 hervorgeht. Die bewegliche Aufnahmeeinheit 18 ist an einem Beginn des Pfades 20 dargestellt. Die Pfeile 22a und 22b zeigen eine beispielhafte Flugrichtung / Bewegungsrichtung der beweglichen Aufnahmeeinheit 18 auf dem Pfad 20 an. Darüber hinaus sind auf dem Pfad 20 Auslösestellen 24 als Markierungen bzw. Punkte eingezeichnet. Die Punkte/Auslösestellen (bzw. eine Punktdichte/Auslösestellendichte auf dem Pfad) können anhand eines Sichtfelds der beweglichen Aufnahmeeinheit, also z.B. anhand eines verwendeten Objektivs der beweglichen Aufnahmeeinheit (d.h. abhängig von der Brennweite) bestimmt werden, z.B. derart, dass sich zwei aufeinanderfolgende Bilder teilweise überlagern. So können Abweichungen in der Positionierung der beweglichen Aufnahmeeinheit kompensiert werden, die bei einer zu knappen Kalkulation der Übergänge zwischen den Bildern nicht aufgenommen würden. Optional kann auch der Abstand des Pfads mit in diese Bestimmung mit einbezogen werden. An diesen Auslösestellen kann die bewegliche Aufnahmeeinrichtung ein Bild von dem Objekt erzeugen. Es ist natürlich auch möglich, ein Video oder zumindest eine Vielzahl von Bildern aufzunehmen, die nicht anhand des oben beschriebenen Verfahrens optimiert sind, jedoch kann sich dadurch die Komplexität der Auswertung erhöhen.

Der Auslösepunkte können beispielsweise so gewählt werden, dass bei Einsatz eines 35mm Objektivs mit einem Vollbildsensor, bei einem Abstand des Pfades zu dem Objekt von 6 Metern und einer Länge des Objekts von 60 Metern ein Abstand von 5 Metern zwischen den Auslösepunkten liegt.

Ferner sind in Fig. 4 zwei Punkte 26a und 26b aus der Menge der Punkte dargestellt. Ausgehend von den Punkten der Menge von Punkten können Koordinaten des Pfades relativ bestimmt werden. Ausführungsbeispiele verwenden ferner Polygonflächen aus der Menge von Punkten, zu denen der Pfad beabstandet verläuft. Der Abstand kann beispielsweise so gelegt werden, dass eine plötzliche Windböe (oder ein anderes unvorhergesehenes Ereignis, dass die bewegliche Aufnahmeeinheit von dem Pfad abbringen kann), die bewegliche Aufnahmeeinheit nicht gegen das Objekt drücken kann (oder zumindest eine Wahrscheinlichkeit deutlich verringert), bevor die bewegliche Aufnahmeeinheit die plötzliche Änderung ausgleichen bzw. ausregeln kann.

In anderen Worten ist in Fig. 4 eine automatisch erstellte Wegepunktplanung aus ursprünglich CAD- und GEO-Daten für die optische Inspektion von Windkraftanlagen gezeigt. Eine Software errechnet dabei (automatisch) die Flugroute (Abstand zum Windradblatt) der Drohne und die Auslösepunkte für Kameraaufnahmen (Punkte 24) abhängig von der verwendeten Brennweite des Kameraobjektives. Die erhaltenen Bilder werden danach auf Grund der hochgenauen Aufnahmen und der hochgenauen Referenzierung zwischen CAD und GPS Daten wieder auf ein Rotorblatt-CAD-Modell projiziert und ergeben ein vollständig texturiertes 3D Modell des Beobachtungsobjektes. Voraussetzung ist das CAD Modell der Windkraftanlage oder ähnliches, sowie ein einziger hochgenau vermessener GPS Ankerpunkt (z.B. am Fuß der Anlage, Sockelpunkt) woraus die Umrechnung der Koordinatensysteme schnell und automatisch erfolgen kann.

In Fig. 4 nimmt die Kameradrohne (=bewegliche Aufnahmeeinheit) Bilder nur beim hoch fliegen entlang des Windradblattes auf. Die Ausführungsbeispiele sind jedoch nicht hierauf limitiert. Ferner ist gezeigt, dass die Drohne das Windradblatt aus zwei verschiedenen Perspektiven aufnimmt. In Ausführungsbeispielen kann nun ein Teil des Pfades, der zwischen dem Aufnehmen des Windradblattes aus der ersten Perspektive und der zweiten Perspektive liegt, manuell eingegeben werden. Die Eingabe kann direkt über die CAD Software erfolgen. Eine Umrechnung der relativen Koordinaten in der Software in die absoluten Koordinaten kann automatisch erfolgen. Ferner kann die Eingabe auch erfolgen, wenn die Drohne bereits im Flug ist. Die Änderung des Pfades erfolgt dann dynamisch.

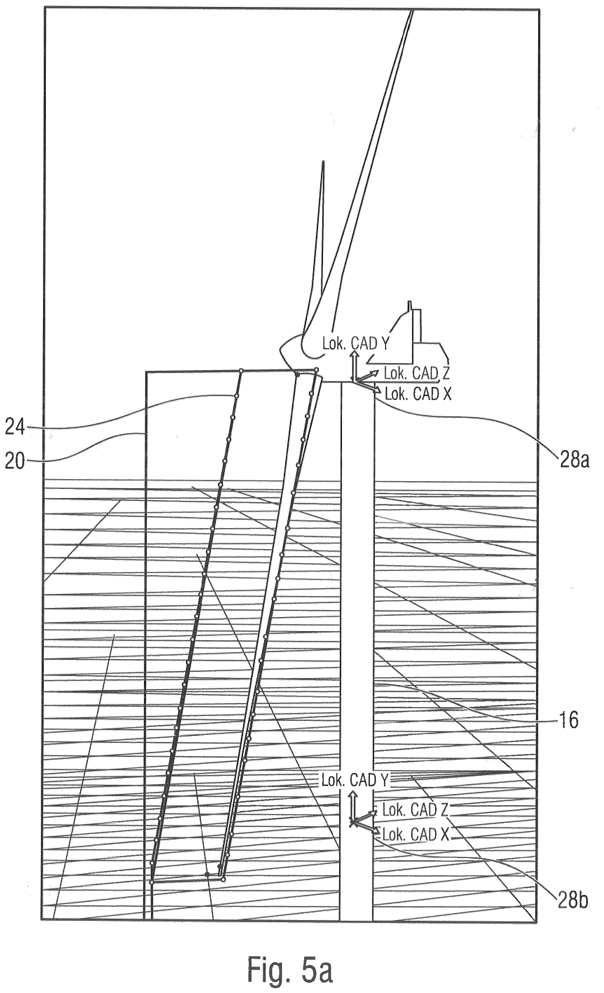

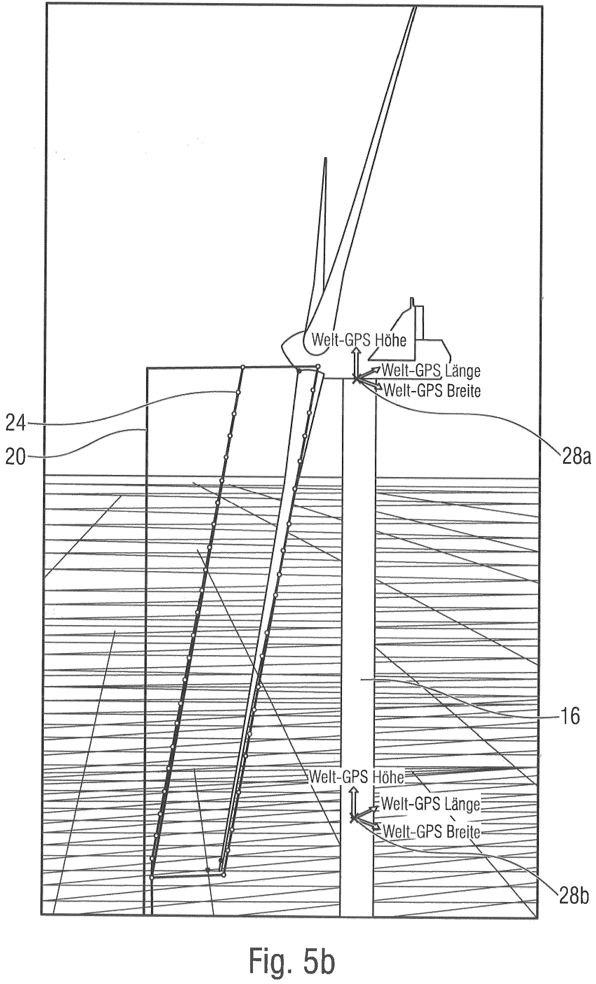

Fig. 5, d.h. Fig. 5a und Fig. 5b, zeigen das Ausführungsbeispiel aus Fig. 4. Fig. 5a zeigt schematisch die 3D Darstellung des Objekts in relativen Koordinaten, beispielsweise in (lokalen) CAD Koordinaten. Dies ist beispielhaft an zwei Punkten 28a, 28b des Objekts anhand der mit Local CAD bezeichneten Koordinatenachsen angedeutet. Basierend auf diesen Koordinaten, die auch nur Abmessungen bzw. Vektoren beispielsweise entlang einer Oberfläche des Objekts sein können, kann die bewegliche Aufnahmeeinheit jedoch noch nicht navigieren. Hierzu ist es vorteilhaft, die Menge der Punkte, oder zumindest eine ausreichende Teilmenge hieraus, in die absoluten Koordinaten zu transformieren. Das Ergebnis ist in Fig. 5b anhand der Punkte 28a, 28b verdeutlicht, die nun in dem absoluten Koordinatensystem vorliegen, also beispielsweise wie in Fig. 5b angedeutet GPS Koordinaten tragen. Die GPS Koordinaten können in Komponenten eines rechtwinkligen Koordinatensystems aufgeteilt werden, deren Achsen mit geographischer Höhe, geographischer Breite und geographischer Länge bezeichnet werden können. Die bewegliche Aufnahmeeinheit kann diese absoluten Koordinaten selber Messen und kennt somit seine aktuelle Position als auch seine Position relativ zu dem Objekt.

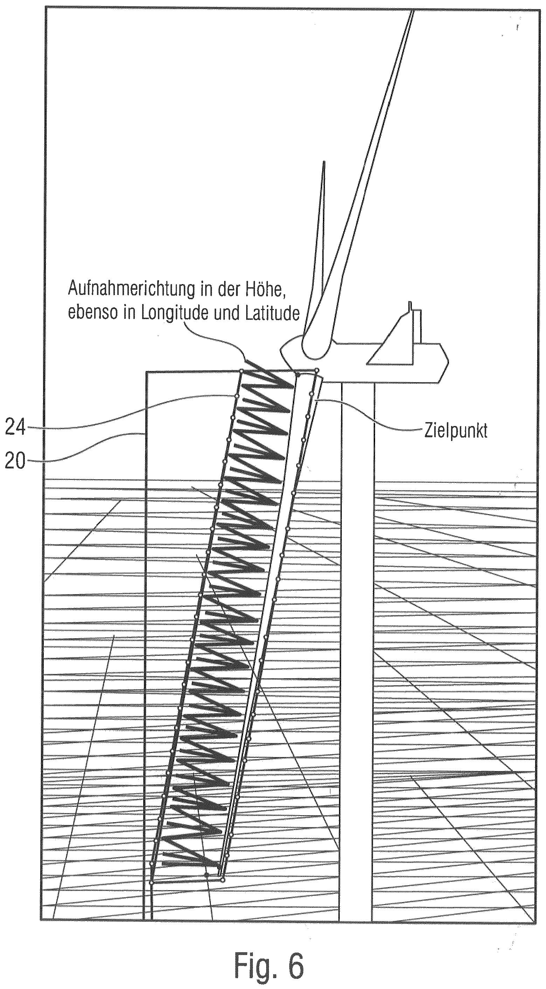

Fig. 6 zeigt das Ausführungsbeispiel aus Fig. 4 und Fig. 5. Ferner zeigt Fig. 6 beispielhaft eine Ausrichtung einer Aufnahmerichtung auf einen Zielpunkt. Der Zielpunkt kann ein Punkt aus der Menge der Punkte des Objekts sein, aus denen die Oberfläche des Objekts in der 3D Darstellung aufgespannt wird. Alternativ kann auch eine beliebige andere Stelle an dem Objekt ausgewählt werden. Die Aufnahmerichtung (oder heading) bezeichnet die Orientierung einer Kamera, die beispielsweise an die Drohne montiert ist. Die Kamera kann dann so auf den Zielpunkt (auch heading target point) ausgerichtet werden, dass dieser beispielsweise (möglichst) in der Mitte des aufgenommenen Bildes angeordnet ist. Die Aufnahmerichtung wird beispielsweise über einen pitch-and-roll (z.B. Roll-Nick-Gier Winkel) Sensor, also einen Sensor, der Neigung und Drehung der beweglichen Aufnahmeeinheit misst, bestimmt. Dieser Sensor kann ein (3-Achsen) Gyroskop sein. Um auf den Zielpunkt zu fokussieren bzw. in dessen Richtung die Aufnahmen zu machen, eine Position der Aufnahmeeinheit verändert werden oder die Aufnahmeeinheit kann derart rotiert werden, dass Sie in die Richtung des Zielpunktes zeigt.

In anderen Worten kann ein Ziel die automatische Erstellung von Flugrouten (z.B. für die Windkraftanlageninspektion mit Drohnen) auf Basis von Wegepunkten innerhalb oder außerhalb von Objekten (indoor, Gebäuden, Outdoor) sein. Dazu kann ein lokales Koordinatensystem des CAD-Objektes der Konstruktionsdaten (z.B. Windrad) umgerechnet werden in ein absolutes geographisches Koordinatensystem (Geo-Centered-Coordinatesystem GCC). Dabei werden erstmals keine relativen Koordinaten erhalten, sondern absolute. Jeder Koordinatenpunkt hat einen unabhängigen Wert von dem Anderen. Das reale Objekt kann allerdings auch separat vermessen werden, so dass die (Gitter-) Punkte des realen Objekts direkt in absoluten geographischen Koordinaten vorliegen.

Für jeden Gitterpunkt des CAD Objektes (Koordinate) wird eine absolute GPS Position errechnet, d.h. die Vertices werden in GPS (GCC) Koordinaten überführt. Dazu können die eigens entwickelten Algorithmen Local2GCC und GCC2GDC verwendet werden. Auf Grund der modernen GPS Technologien und der Verwendung von z.B. RTK (Real Time Kinematik) Korrektursystemen sind Positionsgenauigkeiten bis zu einem Zentimeter möglich. Das bedeutet, dass man, wenn man die Koordinaten des Objektes in geographische Koordinaten wie beschrieben umrechnet, durch einfache Abstandsbestimmung einen Flugweg entlang des Objektes z.B. einer Drohne automatisch generieren, oder interaktiv in einer entsprechenden Software-Engine bestimmen oder verändern kann.

Der Zweck ist, in kartesischen und lokalen Koordinaten definierte 3D Modelle auf einem Globus zu platzieren, indem man einen Punkt auf dem Globus und das zu verwendende Koordinatensystem angibt. Dies kann durch Implementierung beispielsweise der o.g. Funktionen LOCAL2GCC und GCC2GDC in einer 3D-Engine-Software erfolgen. Mit LOCAL2GCC wird ein kartesischer Punkt aus dem Modellkoordinatensystem in geozentrische Koordinaten (ebenso kartesisch aber relativ zum Zentrum des Globus) umgerechnet. Die Funktion GCC2GDC konvertiert diese dann in geodätische Koordinaten (Latitude, Longitude, Altitude).

In der Praxis bedeutet das neuartige Anwendungen für viele Bereiche, wie z.B. Automatischer Drohnenflug (alle denkbaren Flugobjekte und Routen), inklusive Landung und Start ohne Piloten, Navigation in Gebäuden (indoor Navigation), Navigation außerhalb von Gebäuden (Outdoornavigation), Überwachung (Survailance), Flugkörpersteuerung mit Terrainfollowing (Oberflächenverfolgung/Terrainverfolgung) mit gleichen Abstand zur Oberfläche, Lieferung von Gütern mit Drohnen auch innerhalb dicht bebauter Flächen, Vermessung und Inspektion von Infrastruktur, wie z.B. Brücken, Hochspannungsmasten, Ölplattformen, Gebäuden, Industriekomplexen, Fabrikanlagen - Indoor und Outdoor.

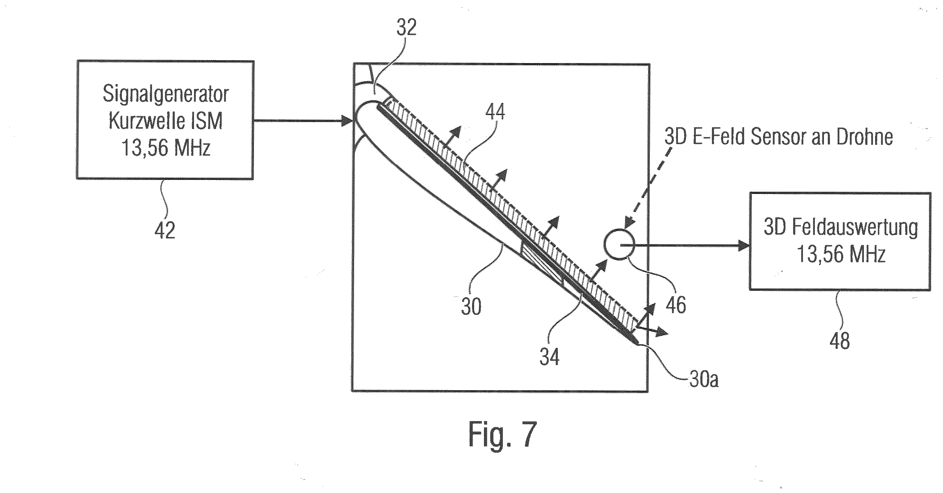

Fig. 7 illustriert ein weiteres Ausführungsbeispiel gemäß dem die bewegliche Aufnahmeeinheit ausgebildet ist, eine Feldstärke eines Feldes berührungslos bzw. kontaktlos zu erfassen, dass durch einen Leiter in dem zu inspizierenden Objekt abgestrahlt wird. Beispielhaft wird diese Ausführungsform anhand eines Windrades erläutert, genauer gesagt anhand einer Blitzschutzmessung. Eine solche Blitzschutzmessung umfasst eine berührungslose Durchgangsprüfung des Blitzableiters eines Rotorblattes des Windrades, der z.B. als Leiter und/oder leitfähiges Netzes ausgebildet sein kann. Fig. 7 zeigt ein Rotorblatt 30 eines Windrades, das an der Nabe 32 angeordnet ist. Der Blitzableiter 34 ist schematisch dargestellt und erstreckt sich von der Nabe 32 bis fast zur Spitze 30a des Rotorblattes 30. In der Gondel des Windrades ist ein Prüfsystem 42 angeordnet, welches in Fig. 7 schematisch dargestellt ist und einen Signalgenerator umfasst, der mit dem Blitzableiter verbindbar ist, um ein Signal an den Blitzableiter anzulegen, welches das zu erfassende Feld hervorruft. Das durch die Anregung erzeugte Feld 44 wird durch einen Feldsensor an einer Drohne 46 erfasst, die das Rotorblatt 30 abfliegt. Ferner ist eine Auswerteeinheit 48 vorgesehen, die als Teil der Drohne oder als hiervon entfernt angeordnete Einheit ausgestaltet ist und das erfasste Feld auswertet.

Somit wird gemäß diesem Ausführungsbeispiel durch das an den Blitzableiter 34 angelegte Signal ein Feld hervorgerufen, das durch den Blitzableiter abgestrahlt wird, und basierend auf dem abgestrahlten Feld wird eine Durchgangsprüfung des Blitzableiters 34 durchgeführt. Das Signal wird z.B. über das Prüfsystem 42 an der Spitze eines Windrads an den Blitzableiter 34 angelegt und die bewegliche Aufnahmeeinheit 46 ist ausgebildet, die Feldstärke in dem Blitzableiter bzw. entlang des Blitzableiters zu messen. Eine Richtung und eine Intensität der erfassten Feldstärke kann ausgewertet werden, um eine Unterbrechung des Leiters 34 zu bestimmen. Ergibt die Messung ein in vorbestimmten Toleranzen kontinuierliches Feld, so wird auf eine nicht-unterbrochene Leitung bzw. Erdleitung geschlossen, also einen funktionsfähigen Blitzableiter. Weicht die Feldstärke an einer oder mehreren Positionen entlang des Leiters von einem vorgegeben Bereich ab, wird auf eine unterbrochene Leitung bzw. Erdleitung geschlossen.

Gemäß dem in Fig. 7 dargestellten Ausführungsbeispiel hat der Leiter bzw. Blitzableiter ein erstes Ende, an das das Signal von dem Prüfsystem angelegt werden kann, und ein zweites Ende, das offen bzw. im Leerlauf ist. Der Leiter bildet somit einen Dipol, und der Signalgenerator des Prüfsystems 42 arbeitet vorzugsweise bei einer Frequenz von 13,56 MHz im Kurzwellenband ISM. Die Anregung des Leiters durch einen Wechselstrom oder eine Wechselspannung von dem Signalgenerator bewirkt eine stehende Welle entlang des Leiters und ein elektrisches Wechselfeld 44, das senkrecht auf dem Leiter steht. Das elektrische Feld 44 wird durch einen Feldsensor, vorzugsweise einen 3D E-Feldsensor, an einer Drohne 46 erfasst, die das Rotorblatt 30 abfliegt. Die Auswerteeinheit 48 wertet das erfasste elektrische Wechselfeld (Frequenz = 13,56 MHz) auf die oben beschriebene Art aus.

Gemäß einem anderen Ausführungsbeispiel ist der Leiter bzw. Blitzableiter eine geschlossene Leiterschleife. Der Signalgenerator des Prüfsystems 42 legt ein Signal, z.B. einen Gleichstrom oder eine Gleichspannung, an die Leiterschleife an, um einen Stromfluss in der Leiterschleife zu bewirken. Der Stromfluss bewirkt ein elektromagnetisches Feld, das den Leiter umgibt. Das elektromagnetische Feld wird durch einen Feldsensor, vorzugsweise einen 3D EM-Feldsensor, an der Drohne erfasst, die das Rotorblatt abfliegt. Die Auswerteeinheit 48 wertet das erfasste elektromagnetische Feld auf die oben beschriebene Art aus.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer BluRay Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmier-baren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinen-lesbaren Träger gespeichert ist. Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Verfahren zum Bestimmen eines Pfades (10, 20) entlang eines Objekts (16) mit folgenden Schritten:
Bestimmen (S102) eines Punktes des Objekts (16) als Referenzpunkt des Objekts (16) in absoluten Koordinaten;
Ermitteln (S104) einer Menge von Punkten des Objekts (16) in absoluten Koordinaten basierend auf weiteren, bekannten Punkten des Objekts (16) in einem relativen Koordinatensystem, wobei die Umrechnung der weiteren Punkte des Objekts (16) in das absolute Koordinatensystem basierend auf dem Referenzpunkt des Objekts (16) erfolgt;
Bestimmen (S106) des Pfads (10, 20) entlang des Objekts (16), anhand eines einzuhaltenden Abstands zu dem Objekt, basierend auf der Menge von Punkten des Objekts (16), so dass der Pfad (10, 20) beabstandet von dem Objekt verläuft.

2. Verfahren gemäß Anspruch 1, wobei das Verfahren ein Verfahren ohne Kenntnis der Position des Objekts (16) in absoluten Koordinaten ist.

3. Verfahren gemäß einem der vorherigen Ansprüche, wobei dem Ermitteln der Menge von Punkten das Erstellen einer 3D Darstellung des Objekts (16) in dem relativen Koordinatensystem, vorangeht.

4. Verfahren gemäß einem der vorherigen Ansprüche, wobei der Pfad (10, 20), z.B. eine Flugbahn, auf dem sich eine bewegliche Einheit, z.B. eine Drohne, entlang des Objekt bewegt, basierend auf einem 3D- oder Gittermodell des Objekts (16) festgelegt wird, und wobei die lokalen Koordinaten des Modells über den zumindest einen Referenzpunkt in absolute Koordinaten zur Steuerung der beweglichen Einheit anhand der absoluten Koordinaten (z.B. GPS Koordinaten) umgewandelt werden.

5. Verfahren gemäß Anspruch 4, wobei eine Bewegung des Objekts (16) oder eines Teils des Objekts (16) in dem Modell in Echtzeit abgebildet wird, und wobei ausgehend von dem modifizierten Modell die Flugbahn in Echtzeit an die Bewegung des Objekts (16) angepasst wird.

6. Verfahren gemäß einem der vorherigen Ansprüche, mit
Bewegen einer beweglichen Aufnahmeeinheit (6, 18, 46) auf dem Pfad (10, 20) entlang des Objekts (16), und
Inspizieren des Objekts (16) entlang des Pfades (10, 20).

7. Verfahren gemäß Anspruch 6, wobei das Inspizieren des Objekts (16) ein kontaktloses Erfassen einer Feldstärke eines Feldes umfasst, dass durch einen Leiter in dem Objekt abgestrahlt wird.

8. Verfahren gemäß Anspruch 7, mit Anlegen eines Signals an den Leiter, um das zu erfassende Feld hervorzurufen.

9. System zum automatischen Inspizieren eines Objekts (16) mit folgenden Merkmalen:
einer beweglichen Aufnahmeeinheit (6, 18, 46), die ausgebildet ist, sich automatisch auf einem Pfad (10, 20) entlang des Objekts (16) zu bewegen; und
einer Recheneinheit, die ausgebildet ist,
einen Punkt des Objekts (16) als Referenzpunkt des Objekts (16) in absoluten Koordinaten zu bestimmen; und
eine Menge von Punkten des Objekts (16) in absoluten Koordinaten basierend auf weiteren bekannten Punkten des Objekts (16) in einem relativen Koordinatensystem zu ermitteln, wobei die Umrechnung der weiteren Punkte des Objekts (16) in das absolute Koordinatensystem basierend auf dem Referenzpunkt des Objekts (16) erfolgt; und
den Pfad (10, 20) entlang des Objekts (16), anhand eines einzuhaltenden Abstands zu dem Objekt, basierend auf der Menge von Punkten des Objekts (16) zu bestimmen, so dass der Pfad (10, 20) beabstandet von dem Objekt verläuft;
wobei die bewegliche Aufnahmeeinheit (6, 18, 46) ausgebildet ist, das Objekt entlang des Pfades (10, 20) zu inspizieren.

10. System gemäß Anspruch 9, wobei die bewegliche Aufnahmeeinheit (6, 18, 46) ausgebildet ist, zum Inspizieren des Objekts (16) eine Abfolge von Bildern von dem Objekt zu erzeugen (S112) oder eine Messung an dem Objekt durchzuführen.

11. System gemäß einem der Ansprüche 9 oder 10, wobei
die Recheneinheit ausgebildet ist, entlang des Pfades (10, 20) Auslösestellen (24) für die beweglich Aufnahmeeinheit (6, 18, 46) abhängig von einem Sichtfeld der beweglichen Aufnahmeeinheit (6, 18, 46) zu definieren; und
die bewegliche Aufnahmeeinheit (6, 18, 46) ausgebildet ist, an den Auslösestellen (24) ein Bild zu erzeugen.

12. System gemäß einem der Ansprüche 9 bis 11, mit einer Auswerteeinheit, die ausgebildet ist, die Bilder von dem Objekt auf ein Modell des Objekts (16) zu projizieren, um ein Modell mit der aktuellen Oberfläche des Objekts (16) zu erhalten.

13. System gemäß Anspruch 12, wobei die Projektion basierend auf einer aktuellen Position und einer Aufnahmerichtung der Aufnahmeeinheit (6, 18, 46) zu einem Zeitpunkt der Bildaufnahme erfolgt.

14. System gemäß einem der Ansprüche 9 bis 13, wobei die bewegliche Aufnahmeeinheit (6, 18, 46) ausgebildet ist, eine Aufnahmerichtung auf einen Punkt aus der Menge der Punkte einzustellen.

15. Computerprogramm mit einem Programmcode zur Durchführung des Verfahrens nach einem der Ansprüche 1 bis 8, wenn das Programm auf einem Computer abläuft.

## Claims

1. Method of determining a path (10, 20) along an object (16), comprising:
determining (S102) a point of the object (16) as reference point of the object (16) in absolute coordinates;
ascertaining (S104) a set of points of the object (16) in absolute coordinates on the basis of further known points of the object (16) within a relative coordinate system, conversion of the further points of the object (16) to the absolute coordinate system being effected on the basis of the reference point of the object (16);
determining (S106) the path (10, 20) along the object (16) based on a distance to be maintained from the object, on the basis of the set of points of the object (16), so that the path (10, 20) extends at a distance from the object.

2. Method as claimed in claim 1, wherein the method is a method without any knowledge of the position of the object (16) in absolute coordinates.

3. Method as claimed in any of the previous claims, wherein said ascertaining of the set of points is preceded by creating a 3D representation of the object (16) within the relative coordinate system.

4. Method as claimed in any of the previous claims, wherein the path (10, 20), e.g. a trajectory on which a movable unit, e.g., a drone, moves along the object, is specified on the basis of a 3D or lattice model of the object (16), and wherein the local coordinates of the model are converted, via the at least one reference point, to absolute coordinates for controlling the movable unit by means of the absolute coordinates (e.g. GPS coordinates).

5. Method as claimed in claim 4, wherein a movement of the object (16) or of part of the object (16) is reproduced in real time in the model, and wherein, on the basis of the modified model, the trajectory is adapted in real time to the movement of the object (16).

6. Method as claimed in any of the previous claims, comprising:
moving a movable capturing unit (6, 18, 46) on the path (10, 20) along the object (16), and
inspecting the object (16) along the path (10, 20).

7. Method as claimed in claim 6, wherein said inspecting of the object (16) includes contactless sensing of a field strength of a field radiated off by a conductor within the object.

8. Method as claimed in claim 7, comprising applying a signal to the conductor so as to cause the field to be sensed.

9. System for automatically inspecting an object (16), comprising:
a movable capturing unit (6, 18, 46) configured to automatically move on a path (10, 20) along the object (16); and
a calculating unit configured to
determine a point of the object (16) as reference point of the object (16) in absolute coordinates; and
ascertain a set of points of the object (16) in absolute coordinates on the basis of further known points of the object (16) within a relative coordinate system, conversion of the further points of the object (16) to the absolute coordinate system being effected on the basis of the reference point of the object (16); and
determine the path (10, 20) along the object (16) based on a distance to be maintained from the object, on the basis of the set of points of the object (16), so that the path (10, 20) extends at a distance from the object;
wherein the movable capturing unit (6, 18, 46) is configured to inspect the object along the path (10, 20).

10. System as claimed in claim 9, wherein the movable capturing unit (6, 18, 46) is configured, for inspecting the object (16), to generate (S112) a sequence of pictures of the object or to perform a measurement on the object.

11. System as claimed in any of claims 9 or 10, wherein
the calculating unit is configured to define, along the path (10, 20), trigger locations (24) for the movable capturing unit (6, 18, 46) as a function of a visual field of the movable capturing unit (6, 18, 46); and
the movable capturing unit (6, 18, 46) is configured to generate an image at the trigger locations (24).

12. System as claimed in any of claims 9 to 11, comprising an evaluating unit configured to project the images of the object onto a model of the object (16) so as to obtain a model having the current surface of the object (16).

13. System as claimed in claim 12, wherein said projection is effected on the basis of a current position and of a capturing direction of the capturing unit (6, 18, 46) at a time of capturing.

14. System as claimed in any of claims 9 to 13, wherein the movable capturing unit (6, 18, 46) is configured to set a capturing direction to a point among the set of points.

15. Computer program comprising a program code for performing the method as claimed in any of claims 1 to 8, when the program runs on a computer.

## Revendications

1. Procédé pour déterminer un trajet le long d'un objet (16), aux étapes suivantes consistant à:
déterminer (S102) un point de l'objet (16) comme point de référence de l'objet (16) en coordonnées absolues;
déterminer (S104) une quantité de points de l'objet (16) en coordonnées absolues sur base d'autres points connus de l'objet (16) dans un système de coordonnées relatives, où la conversion des autres points de l'objet (16) en système de coordonnées absolues a lieu sur base du point de référence de l'objet (16);
déterminer (S106) le trajet (10, 20) le long de l'objet (16) à l'aide d'une distance à maintenir par rapport à l'objet, sur base de la quantité de points de l'objet (16), de sorte que le trajet (10, 20) se situe distant de l'objet (16).

2. Procédé selon la revendication 1, dans lequel le procédé est un procédé sans connaissance de la position de l'objet (16) en coordonnées absolues.

3. Procédé selon l'une des revendications précédentes, dans lequel la détermination de la quantité de points est précédée de la création d'une représentation 3D de l'objet (16) dans le système de coordonnées relatif.

4. Procédé selon l'une des revendications précédentes, dans lequel le trajet (10, 20), par exemple une trajectoire de vol, sur lequel se déplace une unité mobile, par exemple un drone, le long de l'objet, est établi sur base d'un modèle 3D ou d'un modèle grillagé de l'objet (16), et dans lequel les coordonnées locales du modèle sont converties par l'intermédiaire de l'au moins un point de référence en coordonnées absolues pour commander l'unité mobile à l'aide des coordonnées absolues (par exemple des coordonnées GPS).

5. Procédé selon la revendication 4, dans lequel un mouvement de l'objet (18) ou d'une partie de l'objet (16) est reproduit dans le modèle en temps réel, et dans lequel, en partant du modèle modifié, la trajectoire est adaptée en temps réel au mouvement de l'objet (16).

6. Procédé selon l'une des revendications précédentes, avec le fait de
déplacer une unité de capture mobile (6, 18, 46) sur le trajet (10, 20) le long de l'objet (16), et
inspecter l'objet (16) le long du trajet (10, 20).

7. Procédé selon la revendication 6, dans lequel l'inspection de l'objet (16) comporte une détection sans contact d'une intensité d'un champ qui est rayonné par un conducteur dans l'objet (16).

8. Procédé selon la revendication 7, avec le fait d'appliquer un signal au conducteur pour générer le champ à détecter.

9. Système pour inspecter de manière automatique un objet (16), aux caractéristiques suivantes:
une unité de capture mobile (6, 18, 46) qui est conçue pour se déplacer de manière automatique sur un trajet (10, 20) le long de l'objet (16); et
une unité de calcul (4) qui est conçue pour
déterminer un point de l'objet (16) comme point de référence en coordonnées absolues; et
déterminer une quantité de points de l'objet (16) en coordonnées absolues sur base d'autres points connus de l'objet (16) dans un système de coordonnées relatives, où la conversion des autres points de l'objet (16) dans un système de coordonnées absolues a lieu sur base du point de référence de l'objet (16); et
déterminer le trajet (10, 20) le long de l'objet (16) à l'aide de la distance à maintenir par rapport à l'objet, sur base de la quantité de points de l'objet (16) de sorte que le trajet (10, 20) se situe distant de l'objet (16);
dans lequel l'unité de capture mobile (6, 18, 46) est conçue pour inspecter l'objet (16) le long du trajet (10, 20).

10. Système selon la revendication 9, dans lequel l'unité de capture mobile (6, 18, 46) est conçue, aux fins d'inspecter l'objet (16), pour générer (S112) une séquence d'images de l'objet (16) ou pour effectuer une mesure sur l'objet (16).

11. Système selon l'une des revendications 9 ou 10, dans lequel
l'unité de calcul (4) est conçue pour définir, le long du trajet (10, 20), des points de déclenchement (24) pour l'unité de capture mobile (6, 18, 46) en fonction d'un champ de vision de l'unité de capture mobile (6, 18, 46); et
l'unité de capture mobile (6, 18, 46) est conçue pour générer une image aux points de déclenchement (24).

12. Système selon l'une des revendications 9 à 11, avec une unité d'évaluation qui est conçue pour projeter les images de l'objet (16) sur un modèle de l'objet (16) pour obtenir un modèle avec la surface actuelle de l'objet (16).

13. Système selon la revendication 12, dans lequel la projection a lieu sur base d'une position actuelle et d'une direction de capture de l'unité de capture (6, 18, 46) à un moment de la capture d'image.

14. Système selon l'une des revendications 9 à 13, dans lequel l'unité de capture mobile (6, 18, 46) est conçue pour régler une direction de capture sur un point de la quantité des points.

15. Programme d'ordinateur avec un code de programme pour la mise en oeuvre du procédé selon l'une des revendications 1 à 8 lorsque le programme est exécuté sur un ordinateur.
